**Europäisches Patentamt**

**European Patent Office**

**Office européen des brevets**

(19)

(11) Publication number: **0 113 005**
**A1**

(12) # EUROPEAN PATENT APPLICATION

(21) Application number: **83111407.9**

(22) Date of filing: **15.11.83**

(51) Int. Cl.³: **B 41 M 5/24**
**B 41 C 1/10, G 03 F 1/00**

(30) Priority: **30.12.82 US 454743**

(43) Date of publication of application:
**11.07.84 Bulletin 84/28**

(84) Designated Contracting States:
**DE FR GB**

(71) Applicant: **International Business Machines Corporation**
**Old Orchard Road**
**Armonk, N.Y. 10504(US)**

(72) Inventor: **Cohen, Mitchell Simmons**
**23 Gregory Lane**
**Ossining New York 10562(US)**

(72) Inventor: **Sachdev, Krishna Gandhi**
**14 Tanglewood Drive**
**Wappingers Falls New York 12590(US)**

(72) Inventor: **Shen, John Chen-Shyan**
**545 21st Street N.E.**
**Rochester Minnesota 55901(US)**

(72) Inventor: **Pennington, Keith Samuel**
**Londonderry Lane**
**Somers New York 10589(US)**

(74) Representative: **Lewis, Alan John**
**IBM United Kingdom Patent Operations Hursley Park**
**Winchester, Hants, S021 2JN(GB)**

(54) Electroerosion printing materials and methods of use thereof.

(57) Electroerosion recording materials of superior scratch resistance are provided by incorporating a hard, crosslinked polymer film or layer between the support and the removable, thin conductive layer to reduce plastic deformation of the support under stylus writing pressure. The intermediate polymer layer may be unfilled or filled with solid, particles, such as, silica particles. The materials may be used in various printing processes including making directly readable images, direct negatives, and offset masters.

The drawing shows a cross-section of the material. The layer 2 may comprise a thermoset cellulose-butyrate polumer crosslinked with isocyanate.

FIG 1

LUBRICANT LAYER, 4
CONDUCTIVE FILM (Al), 3
CROSSLINKED POLYMER LAYER, 2
POLYMER SUBSTRATE, 1

EP 0 113 005 A1

ELECTROEROSION PRINTING MATERIALS AND METHODS OF USE THEREOF

The invention relates to electroerosion printing and more particularly concerns electroerosion recording or printing materials. Such materials are normally in the form of sheets or webs.

Electroerosion printing is a well-known technique for producing markings, such as, letters, numbers, symbols, patterns, such as, circuit patterns, or other legible or coded indicia on recording material in response to an electric signal which removes or erodes material from the surface of the recording material as the result of spark initiation (arcing).

The surface which is eroded or removed to provide such indicia on the recording material is usually a thin film of conductive material which is vaporized in response to localized heating associated with sparking (arcing) initiated by applying an electric current to an electrode in contact with the surface of a recording material comprising the thin conductive film on a non- conductive backing or support. In the present state of the technology, the thin conductive film is usually a thin film of vaporizable metal, such as, aluminum. Electroerosion materials and processes are useful to produce directly, human readable images, photomasks, etc. For a number of such applications there is needed a flexible substrate and a hard surfaced metal film. Substrates of paper and plastic have been employed with thickness on the order of 2 to 5 mil and as the hard metal films, vapor deposited aluminum films of a thickness on the order of 0.5 to 5 microinches have been utilized. For details on materials heretofore used in electroerosion printing, see U.S. Patent 4,082,902, Suzuki, and U.S. Patent 4,086,853, Figov.

Electroerosion printing is effected by the movement of a stylus or a plurality of styli in relation to the surface of specially prepared recording media. Electrical writing signals are fed to the stylus to provide controlled electrical pulses which generate arcing at the surface of the recording material selectively to heat and remove by evaporation a layer of the recording material; the removed material corresponds to the indicia which are to be recorded.

In the course of this process the stylus is moved in relationship to a surface of the recording material and in contact with the removable layer, e.g., a thin film of vaporizable material usually metal, such as, aluminum.

Due to the fragility of the thin conductive layer and the pressure of the stylus on that layer, severe mechanical scratching has been observed. It is believed that the scratching is attributable to several causes, including plastic deformation of the substrate during writing. The thin conductive film, for example, the vapor- deposited thin aluminum film apparently cannot withstand the high strains generated when the support or substrate is deformed and therefore ruptures resulting in scratching. Also there are occasions when the styli cold-weld to the thin aluminum conductive layer so that the structure suffers shear either at the aluminum-substrate interface or below it in the substrate itself.

U.S. Patent 3,514,325, Davis et al, discloses an electroerosion recording material in which a surface layer of crosslinked binder containing conductive particles such as zinc oxide is placed on top of the thin aluminum layer.

U.S. Patent 3,740,254, Lansbury et al, describes an isocyanate—ended polyurethane composition, i.e., a prepolymer, as a primer for the deposition of thin aluminum films on various substrates including plastic substrates. The purpose here is to improve adhesion of the aluminum film.

U.S. Patent 3,786,518, Atherton, describes an electroerosion recording material comprising, for example, a thin conductive film of aluminum deposited over a resin which has been provided with a matte finish by the inclusion of a matting agent or by treating the resin surface. A wide variety of resinous materials is suggested for the resin layer.

U.S. Patent 4,268,570, Imanaka et al, describes the optional use of a polyurethane adhesive layer between the polymer support and the aluminum layer in plastic molded products, such as, resin plates, tubes, and the like. The structures are unrelated to electroerosion printing.

U.S. Patent 4,217,596, Jung, describes an electroerosion recording paper comprising a layer of lacquer or printing ink or both between the thin conductive aluminum layer and a paper support.

U.S. Patent 4,305,082, Kusakawa et al, describes an electroerosion recording paper in which a resistance layer may be provided over the thin conductive aluminum film.

Finally, U.S. Patent 4,304,806, Anderson et al, describes information-carrying discs coated with an abrasion-resistant polymer layer derived from an epoxy-terminated silane.

U.S. Patent 4,339,758 of Bhatia et al, describes an electrosensitive recording that uses a silicon dioxide containing resinous base layer between support and the overlying metallic film.

In accordance with the present invention, it has been found that electroerosion recording materials having superior resistance to surface abrasion or scratching of the thin conductive film, such as, aluminum, can be produced by providing between the conductive film and the support a thin hard layer of crosslinked polymer having sufficient hardness to substantially eliminate scratching due to plastic deformation of the support without reducing the handling and writing qualities of the recording material. This layer may be unfilled or filled with a small amount of hard particulate materials, such as, silica, which is tightly held in the crosslinked polymer matrix and is resistant to undesired abrasion during scanning by the stylii.

A direct negative may be produced by electroerosion printing using the materials according to the present invention. The direct negative is used in the same manner as a photonegative in a reproduction process. Where such direct negative is to be produced, the hard particulate material must be light transmissive. Silica particles of about 1 to 3 microns are suitable for such hard particulate material.

Where a direct master is to be produced the hard particulate material must be light transmissive. Silica particles of about 1 to 3 micron are suitable for such purpose.

The invention therefore provides, in one of its aspects, electroerosion recording material comprising a non-conductive support, and a thin layer of conductive material capable of being removed by evaporation during electroerosion recording, said material being characterised by comprising an intermediate layer of thin, hard, cross- linked polymer between said support and said layer of conductive material, the toughness of said intermediate layer being sufficient to reduce plastic deformation of said support in response to stylus writing pressure, and the surface roughness of said intermediate layer being sufficient to minimize scratching of said layer of conductive material during the electroerosion recording process, while still serving to scour off from the electroerosion stylus debri formed during electroerosion recording.

The invention also provides, in another of its apsects, a method for producing an offset master comprising providing an electroerosion recording material as aforesaid and subjecting said material to electroerosion to remove said conductive layer and said intermediate layer and to expose said underlying ink receptive support in desired imaged areas, and leaving said ink repellent surface unaffected in non-imaged areas, whereby said electroerosion recording material may be used as an offset master after electroerosion recording.

The invention will now be further described with reference to the accompanying drawings, in which:

Fig. 1 is a cross-sectional view of an electroerosion material in accordance with this invention.

Fig. 2 is a cross-sectional view of a direct negative made in accordance with this invention, and

Fig. 3 is a cross-sectional view of an offset master made in accordance with this invention.

The present invention is concerned with improvements in electroerosion recording materials and in particular such materials useful in the production of offset masters.

In the broadest sense the invention comprises the provision between the thin conductive film and the plastic support member, such as, a polyester, e.g., Mylar, of a hard polymeric film or layer of high tensile strength and high softening temperature which reduces plastic deformation of the support member during electroerosion writing sufficiently so that abrasion of the thin conductive film, usually evaporated aluminum, is minimized. The hardness, thickness and asperities caused by inorganic fillers such as silica, of this intermediate layer is also selected so that the handling and writing characteristics of the recording material are not adversely affected.

According to this invention, a superior hard thin underlayer can be provided for electroerosion recording materials by selection of a crosslinked polymeric material which is sufficiently hard by itself to reduce the scratching due to plastic deformation of the substrate. An advantage of the crosslinked binder is that a relatively low concentration of hard particles can be used but the layer is still extremely hard; in fact, if desired the particles could be omitted entirely and the layer is still hard enough to inhibit scratching. However, when the particles are included, for example in order to scour off debris, the crosslinking fixes them firmly in place, thus reducing the chance that the particles will be picked up and adhere to the styli and hence cause scratching. This is true because we now have hard particles in a hard matrix; if the correct crosslinker is chosen the layer can be tough as well as hard. A further advantage of crosslinking the underlayer is that, if the crosslinker is properly chosen, there will be less tendency to create, during writing, a soft adherent residue which could cake onto the styli and inhibit further writing.

The highly crosslinked hydrophobic polymer coatings of this invention have the desired hardness and tensile strength, high softening temperature, improved moisture barrier properties, decreased flexibility and elongation, and decreased solubility in commonly employed solvents.

Fabrication of composite structures for electroerosion printing applications described in this invention utilizes such crosslinked polymer matrices as base layers which unlike uncrosslinked systems do not yield to high local temperature and pressure produced during printing and thus minimize the scratching problem, and reduce or eliminate generation of soft debris which would adhere to the print head and thus interfere with the printing process. Also, due to superior passivating properties of these crosslinked hydrophobic polymer coatings, their application according to this invention provides a built-in mechanism for corrosion resistance of thin conductive films such as Al with consequent improvement in shelf life and performance reliability of composites designed for electroerosion printing.

From the standpoint of process viability, the factors which dictate our selection of materials and processes for generation of crosslinked base layers include:

(a) Solubility of starting materials so that these can be applied from solution in commonly employed solvents and the resulting coatings can be cured/crosslinked within minutes at temperatures not exceeding 120[C when plastic substrates, such as, polyester, e.g., MYLAR, are employed.

(b)   The cured films must be tack-free so as to eliminate the possibility of blocking on storage in roll form.

(c)   The polymer binders should be compatible with inorganic fillers such as silica to obtain stable dispersions and homogeneous coatings.

(d)   Formulations containing binder-crosslinking agent-filler combinations should have necessary pot life desired for a particular coating environment.

The invention relates to the use of solvent castable polymeric/oligomeric materials containing residual reactive sites such as free hydroxyl, epoxy, olefinic, acetylenic, a, b-unsaturated carbonyl moities, etc., which can be crosslinked by suitable reagents using heat and/or radiation to accelerate the curing process.  With these materials, crosslinking can also be accomplished by thermal or radiation- induced processes without the addition of another crosslinking agent.

Following are representative examples of various crosslinked polymer systems for application according to this invention:

(a)   Urethane crosslinked cellulosic coatings with and without roughness causing particulate material are formed from cellulose derivatives and aromatic or aliphatic polyisocyanates in the presence of suitable dispersing agents, catalysts and wetting agents well known to those skilled in the polyurethane art.  Suitable cellulose derived materials are:  Cellulose Acetate Butyrate (CAB), Ethyl Cellulose (EC), Nitrocellulose, Cellulose Acetate and Cellulose Diacetate, etc.  Alternate materials containing unsubstituted hydroxyl groups for reaction with polyisocyanates to form crosslinked polyurethanes are:  Polyvinylbutryal, Bakelite phenoxy resins, phenolic resins, epoxies such as Eponols and polyether glycols such as "Teracol" (from DuPont), and Poly(Sytrylallyl alcohol).  Typical polyisocyanates that react with available -OH groups of cellulosic binders or alternate systems include Toluene diisocyanate, Diphenylmethane diisocyanate, Hexamethylene diisocyanate-based systems such as Desmodur N-75 (aliphatic prepolymer, Mobay Chemical Co.) and Mondur Resins such as CB-60 and CB-75, and Mondur HC. Melamine crosslinking agents can also be employed to obtain thermoset coatings with the above binders. Inorganic fillers such as $SiO_2$, $CaCO_3$, $TiO_2$ and calcium silicate etc. of particle size ranging from 0.5 um to 10 um can be incorporated by the usual techniques of grinding or milling together with the binder, the urethane solvent such as MEK-Toluene mixture, and a suitable dispersing agent such as Multron R221-75, a saturated polyester resin by Mobay Chemicals.

The urethane forming reactions of the above described binders and urethane prepolymers are catalyzed by organometallic reagents such as stannous oleate, stannous octoate, dibutyl-tin dioctoate, dibutyl-tin dilaurate, calcium or cobalt naphthenate and also tertiary amines. Further acceleration of the crosslinking reaction can be achieved by thermal treatment of the coatings.

(b) Crosslinked polymer coatings with beneficial properties can be obtained by the use of radiation curable acrylated polyurethane oligomers of the type "UVITHANE 783" and "UVITHANE 788" available from Thiokol Chemical Div. Inorganic fillers such as silica can be dispersed by the conventional techniques prior to coating.

Highly crosslinked films can also be obtained by thermal or radiation-induced copolymerization/ co-crosslinking of the above UV curable urethane oligomers with added multifunctional monomers such as pentaerythritol triacrylate (PETA) and trimethylol-propane triacrylate (TMPTA) available from Celanese Corporation.

(c) Desired crosslinked films with or without inorganic fillers can also be formed by thermal, microwave, or UV curing of coatings cast from blends of acrylated cellulosic derivatives and UV curable urethane oligomers descibred in (b), above.

While a number of materials and approaches described above are suitable for hard polymer films desired to achieve superior quality electroerosion printing materials, we have found that excellent anti-abrasion properties and writing characteristics can be achieved by utilizing cellulose derived binders such as cellulose acetate butyrate or ethyl cellulose with polyisocyanates as crosslinking agents. The material may be used unfilled or filled with silica particles.

For optimal performance in terms of faster curing within 3-5 minutes at 100°C or so to provide coatings free of the blocking problem, scratch resistance, debris-free printing, or non-adherent debris, accumulation on the print head during writing, the base coat formulations were typically formed at NCO:OH ratio of 0.7, a silicon particle PVC (pigment volume concentration) of 10, and catalyst concentration (T-9) in the range of 0.5 to 1% based on resin solids.

Measurement of mechanical properties of silica loaded CAB-Urethane films at a PVC of 15 and T-9 concentration of 1%, showed that 6-8 um thick free standing films are quite brittle having only an Instron elongation at break of from about 5 to 10%.

The films of this invention are tough, i.e., sufficiently impact and abrasion resistant as measured by Instron elongation to break testing so as to reduce plastic deformation of the support on which they are deposited thus minimizing scratching. The films are also characterized by a roughness sufficient to minimize scratching of the surface layers during electroerosion printing, but sufficiently rough to scour off from the stylus debris caused by writing. For example, Talysurf Traces of typical filled films show a peak to valley ratio on the order of 1 to 2 micron.

Although the above parameters are for the optimized coatings, there exists a latitude in the formulations without significantly effecting the functional characteristics of films. For example, NCO:OH ratio can be varied from 0.5 to 1, coating thickness between 2-10 um, concentration of silica (or alternate filler) can range from PVC of 2-15 and catalyst concentration (T-9) between 0.5-1.5 based on resin solids for maximum crosslinking during the allowable curing time and temperature.

## EXAMPLE 1

In producing the products of the invention a composition of the following formulation was prepared for the cross-linked base layers:

|  | Parts by weight |
|---|---|
| Cellulose Acetate Butyrate (CAB) | 30.5 |
| Silica (IMSIL A-108H) | 14.4 |
| Methyl Ethyl Ketone (MEK) | 156.1 |
| Toluene | 20.0 |
| Multron R221-75 | 1.0 |

CAB was first dissolved in the solvent mixture and combined with Silica and the dispersing agent (R221-75). The resulting composition was ball milled to obtain a homogeneous dispersion which was combined and thoroughly mixed with the following ingredients to form a final coating mixture.

|  | Parts by weight |
|---|---|
| Desmodur N-75 (isocyanate crosslinker) | 16.5 |
| Stannous Octoate (T-9 catalyst) from M & T chemicals | 0.05 |
| Fluorocarbon Surfactant (FC-430 by 3M) | 0.20 |

This composition was coated on 2 mil thick polyester substrate (Mylar, E.I. du Pont de Nemours ' Co.) and dried/cured at 100-110°C for 3-5 minutes to obtain 5-7 um thick cross-linked polymer film.

On this coating there was deposited 400-500 Å thick aluminum film by
conventional technique such as sputtering or vacuum evaporation.  Finally,
a lubricant film of graphite-binder dispersions such as Electro Dog from
Acheson Colloid Co., as disclosed in YO982-046, was applied using
conventional web coating apparatus followed by drying at 100°C for 5
minutes or so.  The viscosity of the lubricant coat formulation is
adjusted by appropriate dilution such that the thickness of the dry
overcoat is between 2000- 4000 Å or 20-35 microgram/sq. cm.

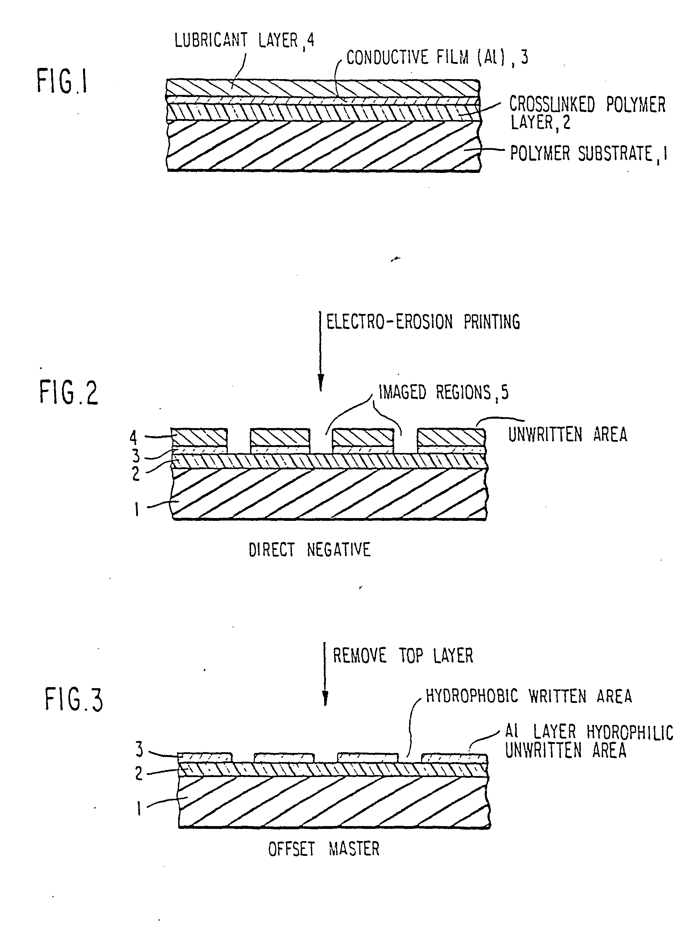

The multilayer structure thus completed is illustrated in Fig. 1 of the
drawing wherein 1 indicates the substrate, e.g., polyester.  Cross-linked
polymer layer 2 is deposited on substrate 1, between the substrate 1 and
conductive film 3, e.g., aluminum.  Lubricant layer 4 is then deposited on
the surface of the aluminum layer.

For the support 1, any suitable material may be used such as various
polymers, e.g., polyester, polyolefins, polycarbonates, polyamides, etc.,
paper or the like.

The lubricant layer 4 preferably comprises a polymer binder-containing
conductive lubricating particles, such as, graphite.  The polymer binder
may be cross-linked material, such as, ethyl cellulose urethane, which is
soluble, permitting removal by solvent to expose the underlying
aluminum/aluminum oxide surface so that the material may be used to
produce an offset master as described below.

When employed as printing material using an electroerosion device at 30-60
volts the material of Fig. 1 may be imaged by clean erosion of aluminum
which, as shown in Fig. 2 of the drawing, is accompanied by the removal of
overlayer in the written or imaged areas 5 thereby exposing the
transparent substrate/base coat with consequent generation of scratch-free
direct negative.

For application of such a printed or imaged material of Fig. 2 as an
offset master, it is necessary to obtain hydrophobic-hydrophilic mapping
so that when an oleophilic ink is employed, the written area remains ink receptive while the unwritten area is non-receptive to oil based inks. Since the direct imaged region of the electro-erosion printing material of the present invention contains hydrophobic cross- linked polymer layer, removal of the lubricant layer 4 from the unwritten areas, as is shown in Fig. 3 of the drawing, using isopropanol or other suitable solvents, exposes areas of hydrophilic aluminum film 6 resulting in the formation of an offset master.

## EXAMPLE 2

The following mixture was ball milled to obtain a Mill Base as homogeneous dispersion prior to preparing final coating formulations A and B.

|  | Parts by weight |
| --- | --- |
| Cellulose acetate butyrate (553.4) | 4.8 |
| Silica (IMSIL A-108H)*/ | 4.4 |
| Methyl ethyl ketone (MEK) | 25.0 |
| Toluene | 5.0 |
| Multron R221-75 | 0.3 |

*/ Amorphous silica from Illinois Mineral
Co., Illinois.

Coating Formulation A (PVC=5)

|  | Parts by weight |
| --- | --- |
| Mill base (prepared above) | 10.0 |
| CAB | 4.0 |
| MEK | 13.0 |
| Toluene | 3.0 |
| CB-75 (Mobay) | 6.2 |
| Stannous octoate (T-9) | 0.009 |
| FC-430 | 0.027 |

This was coated on 2 mil Myler substrate as described in Example 1 to obtain a 5 micron thick dry film. Subsequent coatings of conductive film and lubricant layer provided electroerosion printing material which was used to generate scratch free direct negative and offset master as in Example 1.

Coating Formulation B (PVC=10)

|  | Parts by weight |
|---|---|
| Mill base | 10.0 |
| CAB | 2.0 |
| MEK | 9.0 |
| Toluene | 2.0 |
| Desmodur N-75 | 2.5 |
| T-9 | 0.006 |
| FC-430 | 0.02 |

EXAMPLE 3

A Poly(Styryl Allyl Alcohol)-Silica Mill Base was prepared according to the following formulation:

|  | Parts by weight |
|---|---|
| RJ 101 (Monsanto) | 20.0 |
| MEK | 16.0 |
| Toluene | 4.0 |
| IMSIL A 108-H | 22.0 |
| R 221-75 | 1.0 |

0113005

This mixture was ball milled for 18 hours and the mill base was employed for the following coating:

|  | Parts by weight |
|---|---|
| Mill base | 6.0 |
| Desmodur N-75 | 2.3 |
| T-9 | 0.002 |
| FC-430 | 0.004 |

The cellulose acetate butyrate (CAB) used in the formulation is available from Eastman Chemicals. The material has a hydroxy equivalent weight of 300-400. The preferred material should have two or more reactive hydroxy sites per chain. If less than two active sites exist per chain, the resulting polyurethane is thermoplastic rather than thermosetting since the required crosslinking fails to develop.

The preferred crosslinking agents are isocyanates available from Mobay Chemical as Desmondur N-75 and Mondur CB-60 or Mondur CB-75. The isocyanate compounds used in the binder have a molecular weight of 150-500 per NCO group. The isocyanate has at least three reactive sites, i.e., NCO groups, per chain so that crosslinking and thermosetting properties are established in the resulting polyurethane binder.

While the proportions of the CAB and isocyanate are not absolutely critical, they must be selected so that the proper thermosetting properties are obtained; theoretically, at an NCO/OH ratio of 1.0 the properties associated with molecular weight are optimized. In general, therefore, in using two-component polyurethane coatings of this invention, we prefer to operate in an NCO/OH ratio in the range of 0.8 to 1.2.

The $SiO_2$ pigment should have a particle size of from 1 to 3 microns and should be added to the binder in the range of from about 10 to 30% by weight. The silica particles act as a filler in the system to prevent blocking and also help to improve wear-resistance of the coating during writing.

The catalyst is used to promote reaction between the isocyanate and CAB resin to reduce the curing temperature and curing time. Minimum curing temperature and shortened cure time are important to limit any adverse effects on the substrate, such as, distortion of a polymer substrate, e.g., Mylar.

Suitable catalysts for use in this invention include, but are not limited to tertiary amine type catalysts, such as, 2,4,6-tris(dimethylaminomethyl) phenol, and organo-metallic compounds, such as, stannous octoate, dibutyl tin dilaurate, or other organometallic compounds. Also combinations of tertiary amines with organometallic compounds may be employed. Catalyst concentrations of about 0.1 to 1% by weight of the binder are satisfactory.

The dispersing agent serves to chelate the silica particles such that they are individually suspended within the uncured binder to permit uniform dispersion. The dispersing agent selected in the foregoing example not only is effective as a dispersant but also has the further benefit of reacting with the isocyanate to form a part of the crosslinked polyurethane binder following the curing stage of the process.

The surfactant provides wetting and levelling and flow control functions by reducing the surface tension of the composition to permit smooth defect-free coating.

Several types of volatile non-reactive solvents can be used in the production of the compositions of the invention to reduce the solids content and permit the coating of very thin layers on the substrate. Classes of suitable solvents include, but are not limited to, aromatic solvents, such as, toluene, xylene; ketones, such as, methylethyl ketone and isophorone; and acetates, such as ethylacetate and butylacetate. The

0113005

preferred solvents employed in the composition are about 80 parts by weight methylethyl ketone and 20 parts by weight toluene.

The coatings of the above formulations can then be applied to a suitable substrate, such as, polyester, e.g., MYLAR, or paper at a thickness in the range of from about 100 to 600 microinches using conventional web-coating procedures and equipment. The resulting coating is cured at below 100[C for from 4-5 minutes.

Once the support has been coated as set forth above, a thin conductive film, such as, vaporized aluminum having a resistivity ranging from approximately 0.5 ohms to 5 ohms per square is deposited over the cured, hard layer.

The recording material is then ready for use in a variety of electroerosion printing processes as described above.

While the invention has been described in connection with certain preferred embodiments which have been demonstrated to be particularly effective, other adaptations and embodiments of the invention may be made by those of skill in the art without departing from the scope of the following claims.

CLAIMS

1.  Electroerosion recording material comprising a non-conductive
    support, and a thin layer of conductive material capable of being
    removed by evaporation during electroerosion recording, said material
    being characterised

    by comprising an intermediate layer of thin, hard, cross- linked
    polymer between said support and said layer of conductive material,
    the toughness of said intermediate layer being sufficient to reduce
    plastic deformation of said support in response to stylus writing
    pressure, and the surface roughness of said intermediate layer being
    sufficient to minimize scratching of said layer of conductive
    material during the electroerosion recording process, while still
    serving to scour off from the electroerosion stylus debris formed
    during electroerosion recording.

2.  A material as claimed in claim 1, wherein said conductive material is
    a thin film of aluminum and said intermediate layer comprises a
    thermoset cellulose-acetate-butyrate polymer crosslinked with
    isocyanate.

3.  A material as claimed in claim 1 or 2, wherein said intermediate
    layer further comprises a filler of solid particles in a pigment to
    volume concentration of at least about 5₺1.

4.  A material as claimed in claim 1 or 2, wherein said intermediate
    layer is filled with up to about 30% by weight of said layer of solid
    particles.

5.  A material as claimed in claim 4, wherein said particles are silica.

6.  A material as claimed in any one of claims 1 to 5, wherein said
    support is a transparent or translucent plastic material.

7.  A material as claimed in any one of claims 1 to 6, further comprising a lubricant layer on the surface of said material facing said electroerosion stylus.

8.  A material as claimed in claim 7, wherein said lubricant layer comprises conductive, lubricating particles in a polymer binder.

9.  A material as claimed in claim 8, wherein said particles are graphite.

10. A material as claimed in claim 9, wherein said binder is a cross-linked polymer.

11. A method for producing an offset master comprising

    providing an electroerosion recording material as claimed in any one of claims 1 to 10, and

    subjecting said material to electroerosion to remove said conductive layer and said intermediate layer and to expose said underlying ink receptive support in desired imaged areas, and leaving said ink repellent surface unaffected in non-imaged areas, whereby said electroerosion recording material may be used as an offset master after electroerosion recording.

12. A method for preparing a direct negative by electroerosion recording comprising

    providing an electroerosion recording material as claimed in any one of claims 1 to 10 and

    subjecting said material to electroerosion recording to remove at least said conductive layer in selected imaged areas, creating light transmissive paths through said material in said imaged areas.

FIG.1

LUBRICANT LAYER,4
CONDUCTIVE FILM (Al),3
CROSSLINKED POLYMER LAYER,2
POLYMER SUBSTRATE,1

ELECTRO-EROSION PRINTING

FIG.2

IMAGED REGIONS,5
UNWRITTEN AREA
4
3
2
1

DIRECT NEGATIVE

REMOVE TOP LAYER

FIG.3

HYDROPHOBIC WRITTEN AREA
Al LAYER HYDROPHILIC UNWRITTEN AREA
3
2
1

OFFSET MASTER

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| X,Y | JAPANESE PATENTS REPORT, vol. 80, no. 6, 7th March 1980, page 5, section G, London, GB & JP - B - 80 005 438 (RICOH CO., LTD.) 06-02-1980 --- | 1-12 | B 41 M  5/24 B 41 C  1/10 G 03 F  1/00 |
| X | DE-B-1 054 323  (RENKER-BELIPA) * Column 9, lines 34-42; column 7, lines 36-50 * --- | 1-12 | |
| X | JAPANESE PATENTS REPORT, vol. 79, no. 26, 27th July 1979, page 3, section G, London, GB & JP - B - 79 016 864 (RICOH K.K.) 26-06-1979 --- | 1-12 | |
| Y | FR-A-2 333 406  (SIEMENS) * Claim 9 * --- | 1,12 | |
| Y | WO-A-8 201 346  (R. BOSCH) * Page 7 * --- | 1,11 | TECHNICAL FIELDS SEARCHED (Int. Cl. ³)  B 41 M  5/24 B 41 C  1/10 G 03 F  1/00 |
| Y | DE-A-1 496 152  (R. BOSCH) * Claims * --- | 1,7,11 | |
| Y | JAPANESE PATENT REPORTS, vol. 77, no. 16, 1977, page 3, section G, London, GB & JP - B - 77 013 746 (KOHJIN CO., LTD.) 16-04-1977 --- | 7-9 | |

-/-

The present search report has been drawn up for all claims

| Place of search THE HAGUE | Date of completion of the search 07-03-1984 | Examiner RASSCHAERT A. |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82

| | DOCUMENTS CONSIDERED TO BE RELEVANT | | Page  2 |
|---|---|---|---|

| Category | Citation of document with indication. where appropriate, of relevant passages | Relevant to claim | CLASSIFICATION OF THE APPLICATION (Int. Cl. ³) |
|---|---|---|---|
| A | EP-A-0 035 106   (IBM) <br> * Claims * <br><br> --- | 1 | |
| A | DE-A-2 503 016   (LICENTIA) <br> * Claims * <br><br> ----- | 1 | |
| | | | TECHNICAL FIELDS SEARCHED (Int. Cl. ³) |

The present search report has been drawn up for all claims

| Place of search <br> THE HAGUE | Date of completion of the search <br> 07-03-1984 | Examiner <br> RASSCHAERT A. |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                  
& : member of the same patent family, corresponding document

EPO Form 1503. 03 82